(19) Europäisches Patentamt
European Patent Office
Office européen des brevets

(11) **EP 1 568 138 B1**

(12) **EUROPÄISCHE PATENTSCHRIFT**

(45) Veröffentlichungstag und Bekanntmachung des Hinweises auf die Patenterteilung:
**07.03.2007 Patentblatt 2007/10**

(21) Anmeldenummer: **03785625.9**

(22) Anmeldetag: **16.10.2003**

(51) Int Cl.:
***H03M 1/10*** (2006.01)

(86) Internationale Anmeldenummer:
**PCT/EP2003/011468**

(87) Internationale Veröffentlichungsnummer:
**WO 2004/054111 (24.06.2004 Gazette 2004/26)**

(54) **A/D-WANDLER MIT MINIMIERTEM UMSCHALTFEHLER**

A/D CONVERTER WITH MINIMIZED SWITCHING ERROR

CONVERTISSEUR A/N A ERREUR DE COMMUTATION MINIMISEE

(84) Benannte Vertragsstaaten:
**DE FR GB**

(30) Priorität: **27.11.2002 DE 10255354**

(43) Veröffentlichungstag der Anmeldung:
**31.08.2005 Patentblatt 2005/35**

(73) Patentinhaber: **Infineon Technologies AG**
**81669 München (DE)**

(72) Erfinder: **BOGNER, Peter**
**A-9500 Villach (AT)**

(74) Vertreter: **Charles, Glyndwr et al**
**Reinhard-Skuhra-Weise & Partner,**
**Patentanwälte,**
**Friedrichstrasse 31**
**80801 München (DE)**

(56) Entgegenhaltungen:
**EP-A- 0 430 599        EP-A- 0 550 990**
**US-A- 4 399 426**

**Beschreibung**

Die Erfindung betrifft einen A/D-Wandler, insbesondere einen Pipeline-Wandler.

A/D-Wandler dienen zur Umsetzung eines analogen Eingangssignals in ein digitales Ausgangssignal. Die A/D-Wandelung erfolgt in der Regel durch Vergleich eines unbekannten Analogsignals mit einem bekannten Referenzwert. Für die A/D-Wandelung gibt es eine Reihe unterschiedlicher Wandlungsverfahren, bei denen entweder das Analogsignal verstärkt, d.h. mit einem vorgegebenen Gewichtungsfaktor multipliziert, oder das Referenzsignal geteilt, d.h. mit einem vorgegebenen Gewichtungsfaktor geteilt wird.

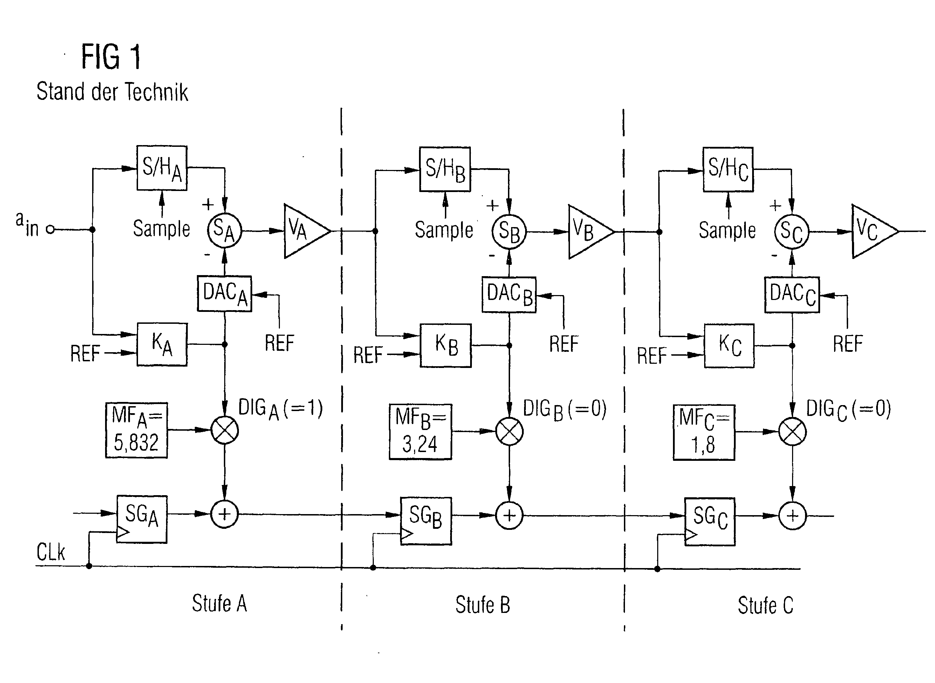

In Figur 1 ist ein dreistufiger Pipeline-Wandler mit den Stufen A,B,C dargestellt. Bei Pipeline-Wandlern wird ebenfalls das Analogsignal ain mit einem Referenzwert verglichen, jedoch wird das unbekannte Analogsignal ain üblicherweise zweifach verstärkt und mit einer konstanten Referenzgröße REF verglichen. Der dargestellte, dreistufige Pipeline-Wandler umfaßt eine Sample&Hold-Stufe $S/H_A$, mit der das analoge Eingangssignal ain abgetastet und gehalten wird. Jede der drei Stufen A-C umfaßt ferner einen Verstärker $V_A$ (bzw. eine Gewichtungseinheit) mit einem Gewichtungs- bzw. Verstärkungsfaktor k=2, sowie einen Komparator $K_A$, mittels dessen das digital umgewandelte analoge Eingangssignal ain mit einem Referenzwert REF verglichen wird. Ist das digital umgewandelte Analogsignal ain größer als der Referenzwert REF, wird der Referenzwert REF vom zweifach verstärkten Analogsignal ain an einem Subtrahierknoten S abgezogen, und der resultierende Differenzwert wird in die Sample&Hold-Stufe $S/H_B$ der nächsten Wandlerstufe B weitergeschoben. Ist dagegen das Analogsignal ain kleiner als der vorgegebene Referenzwert, wird das zweifach verstärkte Analogsignal ain $V_A$ unmittelbar in die Sample&Hold-Stufe $S/H_B$ der Wandlerstufe B weitergeschoben.

Im ersten Fall wird von der Wandlerstufe A ein digitaler Wert logisch "1", und im letzteren Fall ein digitaler Wert logisch "0" erzeugt. Jede der Stufen A-C erzeugt auf diese Weise ein Bit (D/b), die zusammengenommen einen digitalen, binären Code ergeben, der zwischen 0 und $2^n-1$ liegen kann, wobei n die Anzahl der Wandlerstufen ist. Dabei ist das Bitgewicht des digitalen Wandlungsergebnisses wegen des Gewichtungs- bzw. Verstärkungsfaktors 2 der Verstärker V gleich zwei.

Während bei einem Sukzessiven Approximationswandler n Zyklen erforderlich sind, bis das Wandlungsergebnis feststeht, und erst dann wieder eine neue Wandlung gestartet werden kann, ist das Wandlungsergebnis bei dem Pipeline-Wandler, wie er in Fig. 1 gezeigt ist, zwar auch erst nach n-Zyklen gültig, der nächste zu wandelnde Analogwert kann aber bereits nach dem ersten Zyklus der Stufe A in die Pipeline geschoben werden.

Die Genauigkeit der beiden Wandlertypen wird maßgeblich durch die Genauigkeit des Teilungs- bzw.

Multiplikationsfaktors k=2 bestimmt, mit dem das Analogsignal bzw. der Referenzwert multipliziert bzw. geteilt wird. Bei der Gewichtung mit einer Zahlenbasis 2 ist insbesondere die Genauigkeit des Faktors 2, der beim SA-Wandler im Teilungsfaktor 1/2, 1/4, 1/8, etc., und bei dem Pipeline-Wandler im Multiplikationsfaktor 2 auftritt, von Bedeutung. Ein Fehler in einem dieser Gewichtungsfaktoren wirkt sich unmittelbar auf das digitale Endergebnis aus, wie folgendes Beispiel zeigt:

Ein DA-Wandler mit 8 Bit-Auflösung ist in der Lage, ein unbekanntes Analogsignal oder eine Referenzgröße in $2^8=255$ Stufen zu quantisieren. Am A/D-Wandler wird nun ein Analogsignal angelegt, das einer Quantisierungsstufe mit dem dezimalen Wert 128 entspricht. Dieser Analogwert wird nun mit einem Referenzwert verglichen, der durch Teilung einer vorgegebenen Referenzgröße generiert wurde (die vorgegebene Referenzgröße wird beispielsweise mit einem Faktor 3/8 multipliziert). Bei korrekter Teilung würde sich dabei ein Referenzwert ergeben, der einer Quantisierungsstufe von z.B. 127 entspricht, und der kleiner ist als der Analogwert 128. Auf Grund einer Ungenauigkeit des Teilungsfaktors (3/8) führt aber auch noch der Vergleich mit einem Referenzwert, der einem dezimalen Wert von 128 und 129 entspricht, zu dem Ergebnis, dass der Analogwert größer sei als der Referenzwert. Da der Referenzwert der Quantisierungsstufen fälschlicherweise kleiner ist als der Analogwert, wird als Ergebnis des Vergleichs eine "1" anstelle einer "0" ausgegeben.

Neben der Ungenauigkeit bei den von den Wandlern durchgeführten Gewichtungen (Teilung, Multiplikation) wird die Genauigkeit der A/D-Wandler durch transiente Signalspannungen beeinflußt. An den Ein- und Ausgängen der Verstärker V, der Komparatoren K und der Subtrahierknoten S liegen üblicherweise transiente Signale an, die z.B. Überschwingungen aufweisen und erst nach einer bestimmten Abklingzeit auf einen konstanten Wert abklingen.

Bei einem n-Bit-Wandler müssen n Entscheidungen getroffen werden, um ein digitales n-Bit-Wort zu erhalten, wobei jede dieser Entscheidungen mindestens so genau sein muß, wie eine Quantisierungsstufe des endgültigen digitalen Wandlungsergebnis. Die Geschwindigkeit, mit der Vergleiche und andere Operationen bei einem n-Bit-Wandler durchgeführt werden können, ist durch das Zeitverhalten der zu verarbeitenden Signale im Wandler bestimmt. Bei einem SA-Wandler wird relativ viel Zeit benötigt, um die erforderlichen Referenzwerte mit der gewünschten Genauigkeit durch die digitale Steuerung und den DA-Wandler zu generieren. Bei dem Pipeline-Wandler gemäß Fig. 1 wird einige Zeit benötigt, bis die Verstärker V eingeschwungen sind. Werden die vom A/D-Wandler durchgeführten Operationen zu frühzeitig durchgeführt, können daher Fehler entstehen.

Um die Fehlerhäufigkeit zu senken und damit die Genauigkeit der A/D-Wandler zu erhöhen, ist es bereits bekannt, A/D-Wandler mit redundantem Code einzusetzen. A/D-Wandler mit redundantem Code zeichnen sich dadurch aus, dass ein Referenzwert, wie beispielsweise 3/4 einer vorgegebenen Referenzgröße, mit dem das unbekannte Analogsignal verglichen wird, nicht die Grenze des Wertebereichs für einen nachfolgenden Vergleich bildet, sondern je nach Ergebnis des Vergleichs, ein kleinerer oder größerer Wert verwendet wird. Dies sei im folgenden anhand eines Beispiels näher erläutert.

Einem 8-Bit-Wandler, der ein Analogsignal in Werte zwischen 0 und 255 quantisiert, wird ein Analogsignal zugeführt, dessen analoger Wert einem dezimalen, quantisierten Wert von 128 entspricht. In einem Vergleich der Stufe n wird dieser Analogwert mit einem Referenzwert verglichen, der einer Quantisierungsstufe mit dem dezimalen Wert 127 entspricht. Dabei wird festgestellt, dass der Referenzwert kleiner ist als der Analogwert. Um nun Fehler auf Grund ungenauer Gewichtung oder transienter Signalschwankungen zu vermeiden, wird im nächsten, vom A/D-Wandler durchgeführten Vergleich nicht wie üblich der Wertebereich zwischen 127 und 255, sondern ein Wertebereich zwischen einem kleineren Wert, z.B. 120, und 255 gewählt. Dadurch können kleinere Fehlentscheidungen nachträglich noch korrigiert werden und nehmen keinen Einfluss auf das endgültige Wandlungsergebnis.

Bei einem konventionellen, binären Wandler kann dagegen ein Bit, wenn es einmal falsch gesetzt wurde, in den nachfolgenden Konvertierungsschritten nicht mehr korrigiert werden.

Die fehlervermeidende Eigenschaft redundanter A/D-Wandler wird dadurch erreicht, dass die Gewichtungsfaktoren, wie z.B. der Verstärkungsfaktor $V_K$ der Verstärker V oder der Teilungsfaktor, mit dem die digitale Steuerung (Gewichtungseinheit 4) einen Referenzwert aus einer vorgegebenen Referenzgröße generiert, nicht auf einer Zahlenbasis 2 beruhen, sondern eine kleinere Zahlenbasis, z.B. 1,8, zu Grunde gelegt wird.

Bei einem SA-Wandler mit redundantem Code sind dann die Referenzelemente, mit denen die vorgegebene Referenzgröße geteilt wird, nicht doppelt so groß, viermal so groß.... (Referenzelemente können Kapazitäten, Stromquellen, Widerstände etc. sein), sondern kleiner als doppelt so groß, viermal so groß ..... Die Referenzelemente können z.B. ein Bitgewicht des digitalen Ausgangssignals von 1; 1,8; $1,8^2$; $1,8^3$ usw. bewirken. Bei einem Pipeline-Wandler gemäß Fig. 1, bedeutet dies, dass der Gewichtungs- bzw. Verstärkungsfaktor der Verstärker nicht zwei sondern 1,8 betragen müsste.

Die Schwierigkeit bei solchen redundanten A/D-Wandlern besteht darin, dass der Faktor 1,8 nicht so einfach wie der Faktor 2 jeweils durch verdoppeln des Referenzelementes erzeugt werden kann. Dadurch entstehen bereits prinzipiell größere Fehler als bei einem binären Wandler.

Jede der Wandlerstufen A,B,C liefert als Ergebnis des von den Stufen durchgeführten Vergleichs ein Bit DigA, DigB, DigC des digitalen Wandlungsergebnisses. Im gezeigten Beispiel von Fig. 1 wird ein redundanter Code 1,0,0,0 erhalten. Das digitale Wandlungsergebnis ist jedoch nicht binär, mit einem Bitgewicht von zwei, und entspricht daher auch nicht der dezimalen Zahl $2^3=8$, sondern beruht auf der Basis 1,8 und entspricht somit der Zahl $1,8^3= 5,832$. Dieses Ergebnis berechnet sich zu $0.1+0.1,8^1+0.1,8^2+1.1,8^3=5,832$. Die Addition der einzelnen Bits des Wandlungsergebnisses wird mit der in Figur 1 unten dargestellten Anordnung durchgeführt, die zu diesem Zweck Speicher zum Abspeichern von Multiplikationsfaktoren MF, Multiplikation mehrerer Speicherglieder SG und Addierknoten AK aufweist. Aus dem Code mit einem Bitgewicht von 1,8 wird schließlich ein binärer Code erzeugt. Nach dem letzten Addierknoten $AK_C$ (ganz rechts unten) erhält man den zum redundanten Code gehörenden binären Code, also das Wandlungsergebnis in binärer Form.

Fehler im binären Wandlungsergebnis treten insbesondere dann auf, wenn die vom A/D-Wandler durchgeführte Gewichtungen $V_i$ des Analogsignals oder der Referenzgröße nicht genau den gespeicherten Multiplikationsfaktoren entspricht, der bei der Umwandlung des redundanten Codes in einen Binärcode verwendet wird.

Bislang wurde versucht, diesen Fehler durch Verändern der Verstärkungen $V_i$ bei dem Pipeline-Wandler gemäß Fig. 1 in der Wandler-Analogschaltung zu kompensieren. Dies ist jedoch relativ kompliziert.

Es wurde daher in der deutschen Offenlegungsschrift DE 101 33 538.5 A1 ein A/D-Wandler vorgeschlagen, bei dem die Multiplikationsfaktoren $MF_i$ einfach kalibrierbar sind.

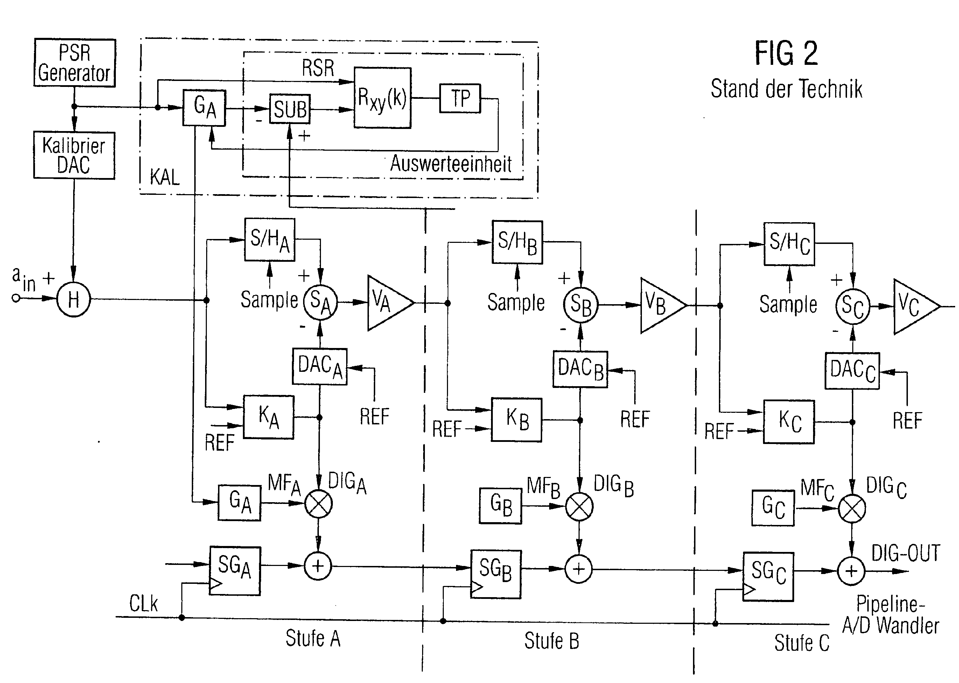

Bei diesem in Fig. 2 dargestellten A/D-Wandler nach dem Stand der Technik wird nicht nur das zu wandelnde Analogsignal bzw. eine Referenzgröße, sondern auch ein Hilfssignal PSR (Pseudo Random) im A/D-Wandler gewichtet und gleichzeitig ein Kalibrierverstärker zur Gewichtung digitalen Zufallssignals PSR vorgesehen, dessen Verstärkungsfaktor verändert werden kann. Der vom A/D-Wandler angewandte Gewichtungsfaktor G wird dadurch ermittelt, dass das vom A/D-Wandler gewichtete Zufallssignal PSR und das von dem regelbaren Kalibrierverstärker gewichtete Hilfssignal PSR (bzw. daraus abgeleitete Signale), sowie das ursprüngliche (ungewichtete) Zufallssignal einer Auswerteeinheit zugeführt werden, die eine Korrelationsanalyse durchführt.

Figur 2 zeigt eine Wandlerstufe A eines herkömmlichen Pipeline-Wandlers mit einer zugehörigen Kalibriereinrichtung KAL. Der Pipeline-Wandler ist ein A/D-Wandler mit redundantem Code und umfasst in üblicher Weise einen Verstärker V mit einem Gewichtungsfaktor 2 einen Komparator K und einen Subtrahierknoten S.

Neben der ersten Wandlerstufe A ist in Figur 2 auch eine zweite Wandlerstufe B und eine dritte Wandlerstufe C gezeigt.

Die Summe des PSR-Signals und des Eingangssignals wird schließlich durch einen Verstärker $V_A$ z.B. einem Faktor $V_A = 2$ verstärkt. Das analoge Summensignal wird an den Komparator außerdem mit einer Referenzgröße REF verglichen. Ist das analoge Summensignal größer als die Referenzgröße REF, wird die Referenzgröße vom 2-fach verstärkten Summensignal abgezogen und der resultierende Wert wird an die nächste Wandlerstufe B abgegeben. Andernfalls wird der 2-fach verstärkte analoge Summensignal, bestehend aus dem analogen Eingangssignal ain und dem digitalem Zufallsignal, unmittelbar ohne Subtraktion des Referenzsignals an die nächste Wandlerstufe B weitergeleitet.

Die Kalibriereinrichtung KAL umfasst eine regelbare digitale Gewichtungseinheit bzw. Kalibrierverstärker und eine Auswerteeinheit.

Das im Pipeline-Wandler erzeugte Teil-Digitalsignal wird am Ausgang der Wandlerstufe B abgegriffen und ebenfalls der Auswerteeinheit zugeführt. Die Auswerteeinheit umfasst einen Subtrahierknoten SUB, mit dem das mit dem Gewichtungsfaktor G der regelbaren digitalen Gewichtungseinheit multiplizierte digitale Zufallssignal PSR vom digital gewandelten Analogsignal subtrahiert wird. Stimmen der Gewichtungsfaktor $G_A$ der regelbaren Gewichtungseinheit und der Verstärkungsfaktor $V_A$ des Verstärkers überein, besteht das resultierende Differenzsignal DIF nur aus dem unkorrelierten Quantisierungsfehler plus dem Eingangssignal. Stimmen der Gewichtungsfaktor und die Verstärkung $V_A$ nicht überein, bleibt auch ein Rest des digitalen Zufallssignals übrig.

Das Differenzsignal DIF kann mit Hilfe einer Korrelationseinheit $R_{xy}$ ausgewertet werden, wobei die Korrelationseinheit eine Kreuzkorrelation des Differenzsignals DIF mit dem ursprünglichen, digitalen Zufallssignal PSR durchführt. Mit dem Ergebnis der Korrelation wird der Gewichtungsfaktor $G_A$ der regelbaren Gewichtungseinheit G nachgestellt, bis im Differenzsignal DIF kein Rest des digitalen Zufallssignals mehr vorhanden ist.

Der Ausgang der Korrelationseinheit $R_{xy}$ ist dabei z. B. über ein Tiefpassfilter TP an die Gewichtungseinheit geschaltet.

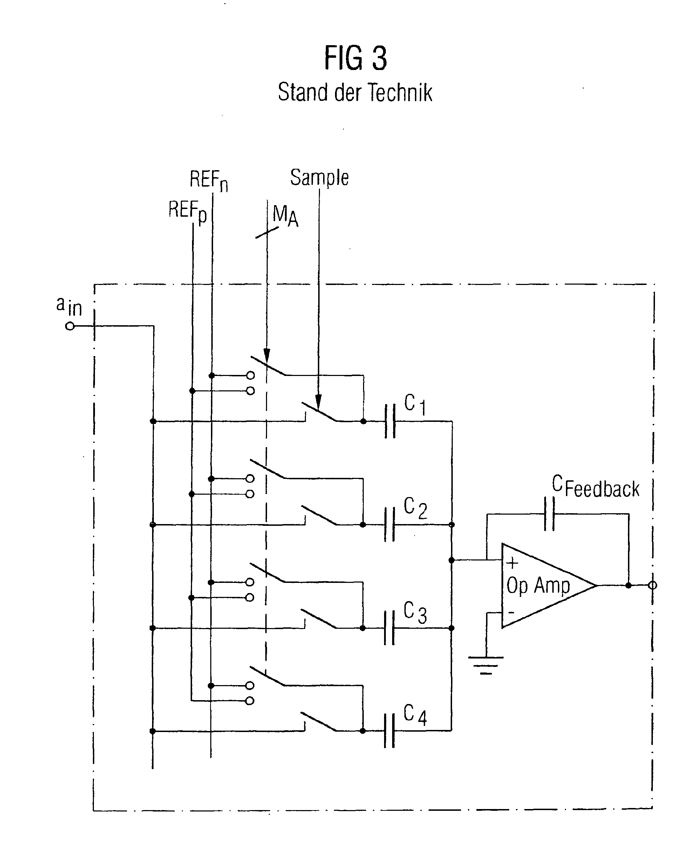

Figur 3 zeigt eine schaltungstechnische Realisierung einer Wandlerstufe des Pipeline-Analog/Digitalwandlers nach dem Stand der Technik.

In Figur 3 ist eine Single-Ended-Implementierung eines 2-Bit Digital/Analog-Konverters mit vier DAC-Kapazitäten C1 bis C4 dargestellt. An den DAC wird ein Referenzsignal REF ein Thermometer-kodiertes Komparatorausgangssignal sowie ein Sample-Steuersignal angelegt. Während der Samplephase wird das analoge Eingangssignal $A_{in}$ an die DAC-Kondensatoren C1 bis C4 angelegt. Die Wandlerstufe umfasst ferner einen rückgekoppelten Operationsverstärker mit Feedback-Kondensator.

Der in Figur 2 dargestellte Pipeline-Analog/Digitalwandler nach dem Stand der Technik weist folgende Nachteile auf.

Zur Einspeisung des digitalen Zufallssignals an den durch die Wandlerstufen gebildeten Signalpfad des Analog/Digitalwandlers ist ein zusätzlicher Kalibrier-Digital/Analogwandler notwendig. Hierdurch wird der schaltungstechnische Aufwand des Analog/Digitalwandlers erhöht.

Die in Figur 3 dargestellte Wandlerstufe nach dem Stand der Technik umfasst verschiedene DAC-Kondensatoren C1, C2, C3 und C4, die aufgrund von Fertigungsstreuungen bzw. Herstellungstoleranzen zu unterschiedliche DAC-Stufen führen. Zum Umschalten von einer DAC-Stufe des Digital/Analogwandlers zu einer anderen DAC-Stufe ergibt sich daher ein Umschaltfehler bzw. DAC-Error. Dieser Umschaltfehler des Digital/Analogwandlers wird in den Signalpfad eingespeist und setzt sich über die Wandlerstufen fort, so dass der digitale Ausgabewert des gesamten Analog/Digitalwandlers verfälscht wird.

EP 0430599 offenbart einen A/D-Wandler wobei Fehler während eines Daten-Abtastverfahren statistisch erkannt und korrigiert werden durch das Anwenden eines Zufallssignals an einem D/A-Wandler, die statistische Überprüfung des Ausgangs des D/A-Wandlers und die Korrelation mit dem Zufallssignal. Deshalb wird der A/D-Wandlerausgang kompensiert, um das Zufallsignal und die Fehler der Elemente des D/A-Wandlers zu entfernen.

Es ist daher die Aufgabe der vorliegenden Erfindung, einen Analog/Digitalwandler zu schaffen, bei dem die Ergebnisverfälschungen aufgrund eines Umschaltfehlers minimal sind.

Diese Aufgabe wird erfindungsgemäß durch einen Analog/Digitalwandler mit den im Patentanspruch 1 angegebenen Merkmalen gelöst.

Die Erfindung schafft einen Analog/Digitalwandler zur Umwandlung eines analogen Eingangssignals ($A_{in}$) in einen digitalen Ausgangswert mit mindestens einer Wandlerstufe, die jeweils aufweist:

eine Sample/Holdschaltung zum Abtastung des analogen Eingangssignals,
eine Komparatoreinheit, die das abgetastete analoge Eingangssignal mit einem Referenzwert zum Erzeugen eines digitalen Ausgabewertes der Wandlerstufe vergleicht,
einen Digital/Analogwandler zur Umwandlung des digitalen Ausgabewertes in ein analoges Signal,
einen Subtrahierer zur Subtraktion des von dem Digital/Analogwandler abgegebenen analogen Signals von dem abgetasteten Eingangssignal und
einen Signalverstärker zum Verstärken des von dem Subtrahierer abgegebenen Ausgabesignals mit einer bestimmten Signalverstärkung für die nächste Wandlerstufe,
eine Gewichtungseinheit zur Multiplikation des digitalen Ausgabewertes mit einem Multiplikator zur Addition mit weiteren gewichteten Ausgabewerten von Wandlerstufen zu einem digitalen Ausgabewert des Analog/Digitalwandlers;

einem Zufallssignalgenerator zur Erzeugung eines Zufallssignals, das in die Wandlerstufe eingespeist wird;

mindestens einer Kalibriereinheit die jeweils aufweist:

einen Kalibrierverstärker mit einstellbarem Kalibrierverstärkungsfaktor zur Signalverstärkung des Zufallssignals,

eine Auswerteeinheit, die das in den Signalpfad eingespeiste und durch die Wandlerstufe verstärkte Zufallssignal mit dem durch den Kalibrierverstärker der Kalibriereinheit verstärkten Zufallssignal zur Erzeugung eines Einstellsignals für die Einstellung des Kalibrierverstärkungsfaktors derart korreliert, dass der Ausgang der Korrelationseinheit gegen null geht und so der berechnete Kalibrierverstärkungsfaktor der Verstärkung entspricht, die durch den Digital/Analogwandler und den Signalverstärker der Wandlerstufe hervorgerufen wird, wobei das Zufallssignal von dem Zufallssignalgenerator über eine durch die Kalibriereinheit steuerbaren Schalter an einen Kalibrierkondensator ($C_{Kal}$) innerhalb des Digital/Analogwandlers der Wandlerstufe zur Einspeisung in den Signalpfad angelegt wird, wobei

das Zufallssignal an weitere DAC-Kondensatoren ($C_i$) innerhalb des Digital/Analogwandlers zur Berechnung der jeweiligen Signalverstärkungen der DAC-Stufen des Digital/Analogwandlers schaltbar ist und

die Kalibriereinheit aus den ermittelten Signalverstärkungen ($V_i$) der DAC-Stufen des Digital/Analogwandlers die Signalverstärkungsdifferenzen $\Delta V_{IJ}$ zwischen den DAC-Stufen zur Berechnung eines Umschaltfehlers (DAC-Errors) des Digital/Analogwandlers berechnet.

Ein Vorteil des erfindungsgemäßen Analog/Digitalwandlers besteht darin, dass kein zusätzlicher Kalibrier-Digital/Analogwandler notwendig ist, sondern vielmehr der in der Wandlerstufe bereits vorhandene Digital/Analogwandler zur Einspeisung des digitalen Zufallssignals eingesetzt wird. Hierdurch wird der schaltungstechnische Aufwand des erfindungsgemäßen Analog/Digitalwandlers verringert.

Bei einer bevorzugten Ausführungsform des erfindungsgemäßen Analog/Digitalwandlers wird der berechnete Umschaltfehler (DAC-Error) von dem digitalen Ausgabewert der Wandlerstufen mittels eines Subtrahierers zur Fehlerkompensation abgezogen.

Bei einer weiteren bevorzugten Ausführungsform werden die berechneten Signalverstärkungen ($V_i$)

in Registern der Kalibriereinheit zwischengespeichert.

Die Kalibriereinheit berechnet vorzugsweise einen Mittelwert der zwischengespeicherten Signalverstärkungen, die durch die verwendeten DAC-Kondensatoren ($C_1$, $C_2$, $C_3$, $C_4$) hervorgerufen werden.

Dieser berechnete Mittelwert der Signalverstärkungen wird vorzugsweise durch die Kalibriereinheit als Multiplikator an die Gewichtungseinheit der Wandlerstufe angelegt.

Bei einer bevorzugten Ausführungsform ist dem Kalibrierverstärker der Kalibriereinheit eine Subtrahierschaltung nachgeschaltet, die das durch den Kalibrierverstärker verstärkte Signal von einem aus dem Signalpfad der Wandlerstufen abgeleiten Signal subtrahiert und ein Differenzsignal an die Auswerteeinheit abgibt.

Die in der Kalibriereinheit enthaltene Auswerteeinheit führt vorzugsweise ein Kreuzkorrelation zwischen dem Differenzsignal und dem Zufallssignal durch.

Der Auswerteeinheit ist vorzugsweise ein Filter nachgeschaltet.

Bei einer bevorzugten Ausführungsform weist die Kalibriereinheit eine Ablaufsteuerung zur Generierung von Steuersignalen für die Ansteuerung von Schaltern auf.

Die Ausgabewerte der Komparatoreinheiten werden vorzugsweise Thermometer-kodiert.

Bei einer bevorzugten Ausführungsform des erfindungsgemäßen Analog/Digitalwandlers weist dieser mindestens zwei Wandlerstufen, beispielsweise fünf Wandlerstufen, auf.

Der Analog/Digital-Wandler ist vorzugsweise voll differentiell aufgebaut.

Im weiteren werden bevorzugte Ausführungsformen des erfindungemäßen Analog/Digitalwandlers unter Bezugnahme auf die beigefügten Figuren zur Erläuterung erfindungswesentlicher Merkmale beschrieben.

Es zeigen:

Figur 1 einen Pipline-Analog/Digitalwandler nach dem Stand der Technik;

Figur 2 einen weiteren Pipeline-Analog/Digitalwandler mit einer Kalibriereinheit nach dem Stand der Technik;

Figur 3 eine schaltungstechnische Implementierung einer Wandlerstufe nach dem Stand der Technik;

Figur 4 ein Blockschaltbild einer bevorzugten Ausführungsform des erfindungsgemäßen Analog/Digitalwandlers;

Figur 5 eine bevorzugte Ausführungsform einer schaltungstechnischen Implementierung einer Wandlerstufe bei dem erfindungsgemäßen Analog/Digitalwandler.

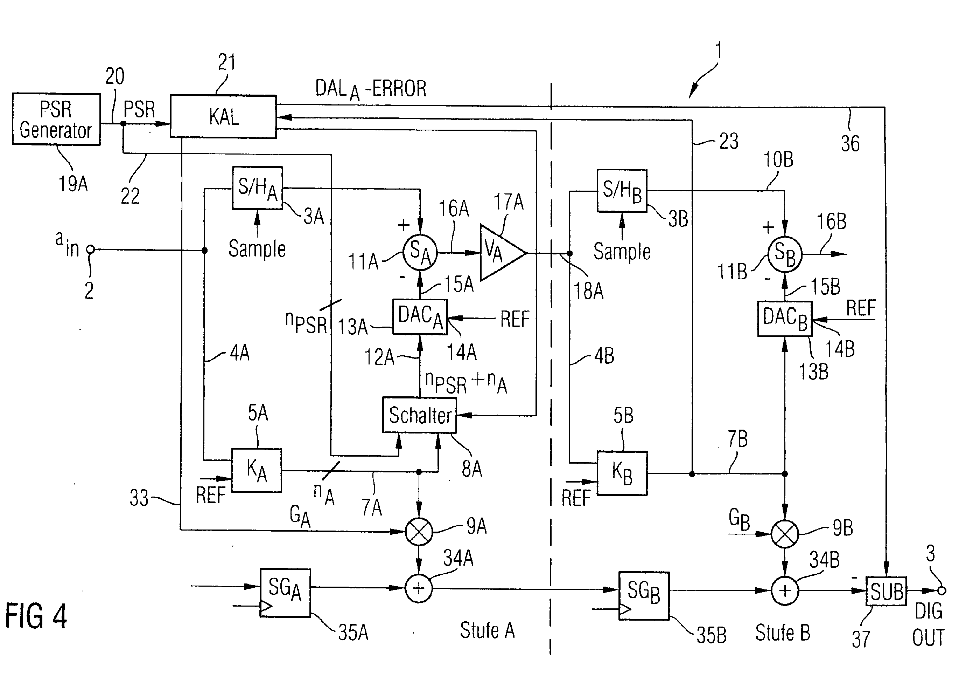

Figur 4 zeigt eine bevorzugte Ausführungsform eines erfindungsgemäßen Analog/Digitalwandlers 1. Bei dem in Figur 4 dargestellten Beispiel sind lediglich zwei Wandlerstufen (Stufe A, Stufe B) zur Vereinfachung der Darstellung gezeigt. Der erfindungsgemäße Analog/Digitalwandler 1 weist vorzugsweise mindestens zwei Wandlerstufen auf. Bei einer möglichen Ausführungsform erhält der erfindungsgemäße Analog/Digitalwandler 1 sechs Wandlerstufen.

Die Wandlerstufen sind seriell hintereinander verschaltet und bilden einen Signalpfad innerhalb des Analog/Digitalwandlers 1. Der Analog/Digitalwandler 1 gemäß der Erfindung weist einen analogen Signaleingang 2 und einen digitalen Ausgang 3 auf. Das an dem Signaleingang 2 anliegende analoge Eingangssignal ($A_{in}$) wird der ersten Wandlerstufe A zugeführt. Die Wandlerstufe A enthält eine Sample&Hold-Schaltung 34 die durch ein Sample-Steuersignal angesteuert wird. Das analoge Eingangssignal ain wird über eine Leitung 4A einer Komparator-Einheit 5A zugeführt, die das abgetastete analoge Eingangssignal mit einem Referenzwert REF zum Erzeugen eines digitalen Ausgabewertes der Wandlerstufe A vergleicht. Der digitale Ausgabewert der Komparatoreinheit 5A wird über mindestens eine Bit-Leitung 7A einer in der Wandlerstufe A vorgesehenen Schalteinrichtung 8A und einer Gewichtungseinheit 9A zugeführt. Bei dem digitalen Ausgabewert kann es sich beispielsweise um ein einziges Ausgabebit handeln. Das von der Sample&Hold-Schaltung 3A abgetastete Eingangssignal wird ferner über eine Leitung 10A einem Subtrahierer 11A zugeführt. Der Schalter 8A ist ausgangsseitig über Leitungen 12A mit einem Digital/Analogwandler 13A verbunden, der den digitalen Ausgabewert in ein analoges Ausgangssignal umwandelt. Hierzu erhält der Digital/Analogwandler 13A über einen Eingang 14A ein Referenzsignal REF. Der Digital/Analogwandler 13A gibt das erzeugte analoge Ausgangssignal über eine Leitung 15A an den Subtrahierer 11A ab. Der Subtrahierer 11A subtrahiert das von dem Digital/Analogwandler 13A erzeugte analoge Ausgangssignal von dem abgetasteten Eingangssignal und gibt das erzeugte Differenzsignal über eine Leitung 16A an einen Signalverstärker 17A ab. Der Signalverstärker 17A verstärkt das von dem Subtrahierer 11A abgegebene Differenzsignal mit einer bestimmten Signalverstärkung $V_A$. Der Ausgang des Signalverstärkers 17A ist über eine Leitung 18A mit einer weiteren Sample/Hold-Schaltung 3B verbunden. Die der Wandlerstufe A nachgeschaltete Wandlerstufe B ist in gleicher Weise wie die Wandlerstufe A aufgebaut.

Der erfindungsgemäße Analog/Digitalwandler 1 enthält einen Zufallssignalgenerator 19, der über eine Leitung 20 eine Kalibriereinheit 21 mit einem Zufallssignal, vorzugsweise einem digitalen Zufallssignal PSR, versorgt. Die Kalibriereinheit 21 ist schaltungstechnisch wie in Figur 2 dargestellt aufgebaut. Das von dem Zufallssignalgenerator 19 erzeugte digitale Zufallssignal PSR wird über Signalleitungen 22 an den Schalter 8A der ersten Wandlerstufe A angelegt und über den Schalter 8A in den Signalpfad der Wandlerstufe 8A eingespeist. Das eingespeiste digitale Zufallssignal PSR gelangt über den Digital/Analogwandler 13A und den Subtrahierer 11A zu dem Verstärker 17A der ersten Wandlerstufe A und wird dort verstärkt. Das verstärkte digitale Zufallssignal wird an die nächste Wandlerstufe B abgegeben und im weiteren Signalpfad des Analog/Digitalwandlers 1 abgegriffen. Bei dem in Figur 6 dargestellten Beispiel wird das verstärkte digitale Zufallssignal am Ausgang des Komparators 5B der nächsten Wandlerstufe B über eine Leitung 23 abgegriffen und der Kalibriereinheit 21 zur Auswertung zugeführt. Die in der Kalibriereinheit 21 enthaltene Auswerteeinheit korreliert das in den Signalpfad eingespeiste und durch die Wandlerstufe A verstärkte Zufallssignal mit dem durch den Kalibrierverstärker der Kalibriereinheit verstärkten Zufallssignals zur Erzeugung eines Einstellsignals für die Einstellung des KalibrierVerstärkungsfaktors bis das Ausgangssignal der Auswerte bzw. Korrelationseinheit gegen null geht und der berechnete bzw. eingestellte Kalibrier-Verstärkungsfaktor der Verstärkung V entspricht, die durch den Digital/Analogwandler 13A und den Signalverstärker 17A der Wandlerstufe A hervorgerufen wird.

Die Kalibriereinheit 21 steuert über Steuerleitungen 24 Schalter 8A in der Wandlerstufe A an. Hierzu enthält die Kalibriereinheit 21 vorzugsweise eine Ablaufsteuerung. In Abhängigkeit von dem Steuersignal werden die Schalter in der Schalteinrichtung 8A geschaltet. Hierbei wird zunächst das digitale Zufallssignal PSR mittels eines Schalters über einen Kalibrierkondensator $C_{cal}$ innerhalb des Digital/Analogwandlers 13A der Wandlstufe A in den Signalpfad eingespeist. Anschließend wird das digitale Zufallssignal PSR sukzessive in Abhängigkeit von den Steuersignalen an die weiteren DAC-Kondensatoren ($C_j$) innerhalb des Digital/Analogwandlers 13A zur Berechnung der jeweiligen Signalverstärkungen der DAC-Stufen des Digital/Analogwandlers geschaltet.

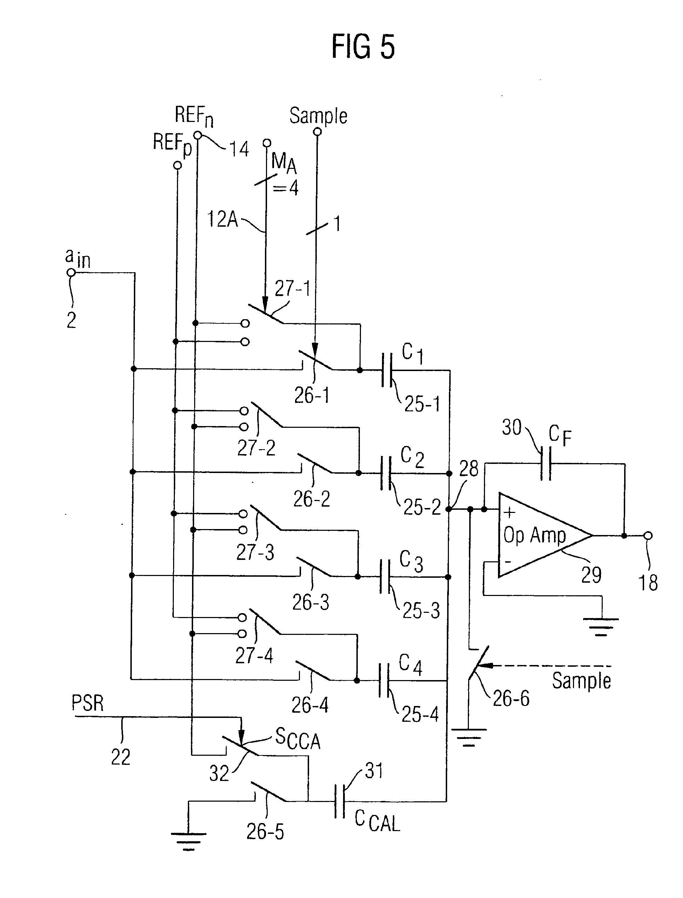

Figur 5 zeigt eine schaltungstechnische Implementierung der ersten Wandlerstufe A gemäß der Erfindung.

Figur 5 zeigt eine Single-ended-Implementierung eines 2-Bit Digital/Analogwandlers mit 4-DAC-Kondensatoren 25-1, 25-2, 25-3, 25-4. Die DAC-Kondensatoren 25 sind über steuerbare Schalter $26_i$ an das analoge Eingangssignal $A_{in}$ schaltbar. Die Schalter $26_i$ werden über ein Sample-Steuersignal, das von einer zentralen Ablaufsteuerung stammt, angesteuert. Während der Sample-Phase wird das analoge Eingangssignal $A_{in}$ an die DAC-Kondensatoren 25 angelegt, d.h. die Schalter $26_i$ sind geschlossen. Die DAC-Kondensatoren 25 sind ferner über steuerbare Schalter 27 an analoge Referenzspannungen REFp, REFn schaltbar. Die Schalter 27 werden durch den von der Komperatoreinheit 5 abgegebenen digitalen Ausgabewert angesteuert. Der Ausgabewert ist vorzugsweise Thermometer-kodiert. Die DAC-Kondensatoren 25 sind an einen Subtrahierknoten 28 angeschlossen. Dem Subtrahierknoten 28 ist ein Operationsverstärker 29 nachgeschaltet, der einen Feedback-Kondensator 30 aufweist.

Während der Samplephase sind die Schalter $26_i$ geschlossen, der Schalter 32 ist offen und die DAC-Kondensatoren 25 liegen an $a_{in}$. In der anschließenden Verstärkungsphase sind die Schalter $26_i$ offen, der Schalter 32 ist geschlossen und die DAC-Kondensatoren 25 liegen an REFn oder REFp in Abhängigkeit von der Entscheidung der Komparatoreinheit. Für die Verstärkung

$$V = \frac{\overline{\sum c_i}}{C_F},$$

wenn $C_1=C_2=C_3=C_4$ und $C_F=2C$;
ergibt sich beispielsweise V=2.

Die dynamic range, d. h. das Verhältnis der Amplitude des Ausgangssignals zu der Maximalamplitude beträgt 50 %. Die bestehende Redundanz wird ausgenutzt zur Einspeisung des digitalen Zufallssignals in den Signalpfad.

Durch die Erhöhung der Anzahl der ansteuerbaren Kondensatoren 25 und der damit verbundenen Erhöhung der Anzahl von Komparatoren innerhalb der Komparatoreinheit 5A wird bei konstantem Verhältnis der Kapazitäten der DAC-Kondensatoren zu der Kapazität des Feedback-Kondensators ($\Sigma C_i/C_F$) die Redundanz erhöht und die dynamic range am Ausgang der Wandlerstufe verringert. Hierdurch wird eine Übersteuerung verhindert. Redundanz bedeutet in diesem Zusammenhang, dass die Anzahl der Komparatoren innerhalb der Komparatoreinheit 5A höher ist als notwendig.

Neben den DAC-Kondensatoren 25 weist die Wandlerstufe, wie sie in Figur 5 dargestellt ist, erfindungsgemäß einen Kalibrierkondensator 31 auf. Der Kalibrierkondensator 31 ist über einen Schalter 32 an die Referenzspannung REF schaltbar. Der Schalter 32 wird durch das über die Leitung 22 zugeführte digitale Zufallssignal PSR angesteuert. Hierdurch wird das digitale Zufallssignal PSR über den Kalibrierkondensator 31 in den Signalpfad des Analog/Digitalwandlers 1 eingespeist. Zwischen den verschiedenen DAC-Kondensatoren 25-1 bis 25-4 besteht aufgrund von Herstellungstoleranzen ein Missmatch-Fehler.

Die Signalverstärkung der in Figur 5 dargestellten Wandlerstufe hängt von dem Verhältnis $\dfrac{\sum C_i}{C_F}$ ab und wird verfälscht durch den nicht idealen Op Amp 29 sowie die Herstellungstoleranzen der Kondenstoren 25. Zunächst wird die Signalverstärkung CAL durch die Kalibriereinheit 21 berechnet, indem das digitale Zufallssignal PSR den Schalter 32 ansteuert. Das eingespeiste digitale Zufallssignal PSR wird entsprechend dem Verhältnis der Kapazität (CAL) des Kalibrierkondensators 31 und des Feedback-Kondensators 30 verstärkt. In der nächsten Wandlerstufe wird das eingespeiste Kalibriersignal abgezweigt und der Kalibriereinheit 21 über die Leitung 23 zugeführt. Das verstärkte Zufallssignal PSR wird mit dem durch den in der Kalibriereinheit 21 enthaltenen, verstärkten Zufallssignal korreliert und der Kalibrierungsverstärkungsfaktor eingestellt, bis der berechnete Kalibrierungsverstärkungsfaktor der Verstärkung in dem Signalpfad entspricht.

Anschließend steuert die Kalibriereinheit 21 über die Steuerleitung 24 (nicht dargestellt), Schalter derart an, dass das zugeführte digitale Zufallssignal sukzessive oder zufällig bzw. in einer beliebigen Reihenfolge an die verschiedenen DAC-Kondensatoren 25-1 bis 25-4 geschaltet wird. In gleicher Weise berechnet anschließend die Kalibriereinheit 21 die verschiedenen Signalverstärkungen V1, V2, V3, V4. Die berechneten fünf Signalverstärkungen $V_{Kal}$ ($C_{Kal}$), V1 (C1), V2 (C2), V3 (C3), V4 (C4) werden in Register der Kalibriereinheit 21 zwischengespeichert. Die Kalibriereinheit 21 berechnet anschließend aus den vier zwischengespeicherten Signalverstärkungen V1, V2, V3, V4 der DAC-Kondensatoren 25-1, 25-2, 25-3, 25-4 einen Mittelwert V = (V1 + V2 + V3 + V4) : 4 und gibt diesen ermittelten Verstärkungsfaktor als Multiplikator über die Leitung 33 an die Gewichtungseinheit 9A der ersten Wandlerstufe A ab. Darüber hinaus berechnet die Kalibriereinheit 21 die Differenzen $\Delta V_{IJ}$ zwischen den zwischengespeicherten Signalverstärkungen V, die den jeweiligen Umschaltfehler zwischen den unterschiedlichen DAC-Stufen entsprechen. Dieser DAC-Fehler bzw. DAC-Error beinhaltet auch das Einschalten der Kalibrierkapazität 31.

Die von den Wandlerstufen abgegebenen, durch die Gewichtungseinheiten 9 gewichteten Ausgabewerte werden mittels Addierern 34 und Schiebegliedern 35 zu einem digitalen Ausgabewert des Analog/Digitalwandlers 1 summiert.

Der von der Kalibriereinheit 21 berechnete DAC-Error wird über eine Leitung 36 einem Subtrahierer 37 zugeführt. Der berechnete Umschaltfehler bzw. DAC-Error wird durch den Subtrahierer 37 von dem ermittelten digitalen Ausgabewert der Wandlerstufen zur Fehlerkompensation abgezogen.

Die durchgeführte Kalibrierung erfolgt bei dem erfindungsgemäßen Analog/Digitalwandler 1 ständig im Hintergrund (Background-Kalibration). Mit dem erfindungsgemäßen Analog/Digitalwandler 1 werden sowohl Signalverstärkungsfehler als auch Umschaltfehler bzw. DAC-Fehler ausgeglichen. Die Fehler werden dabei kontinuierlich digital berechnet. Ein aufwendiges Trimmen ist nicht mehr erforderlich. Auch die Drift bei der Umgebungstemperatur und der Versorgungsspannung wird dabei kontinuierlich ausgeglichen. Mit Ausnahme der zusätzlich notwendigen Kalibrierkapazität 31 kann die Implementierung der Kalibrierung vollständig digital erfolgen.

Bei dem erfindungsgemäßen Kalibriervorgang wird zur Bestimmung der Kapazität eines DAC-Kondensators und zur Bestimmung der zugehörigen Verstärkung des DAC-Kondensators diese Kapazität gegen die Kapazität des Kalibrierkondensators ausgetauscht. Aus dem Gewicht kann die Gesamtverstärkung und der Stufenunterschied berechnet werden und im digitalen Bereich eine Korrektur des berechneten digitalen Ausgabewertes vorgenommen werden. Die in den Wandlerstufen vorgesehenen Digital/Analogwandler 13 sind vorzugsweise vollständig differentiell aufgebaut und weisen eine hohe Auflösung auf. Die Auflösung kann beispielsweise 4,5 Bit betragen.

Die in Figur 4 dargestellte Kalibriereinheit 21 kann für jede Wandlerstufe separat vorgesehen werden. Bei einer bevorzugten Ausführungsform ist nur eine Kalibriereinheit 21 vorgesehen, die mittels eines Multiplexers an die unterschiedlichen Wandlerstufen schaltbar ist.

Bezugszeichenliste

| 1 | SA-Wandler |
|---|---|
| 2 | S/H-Stufe |
| 3 | Komparator |
| 4 | digitale Steuerung (Gewichtungseinheit) |
| 5 | D/A-Wandler |
| 6 | Ausgang |
| 10 | Pipeline-Wandler |
| 11 | S/H-Stufe |
| 12 | Verstärker |
| 13 | Komparator |
| 14 | Subtrahierknoten |
| 15 | Speicherglied |
| 16 | Addierknoten |
| 17 | Addierknoten |
| 18 | digitales Zufallssignal |
| 19 | D/A-Wandler |
| 20 | digitale Gewichtungseinheit |
| 21 | Subtrahierknoten |
| 22 | Korrelationseinheit |
| 24 | Signalpfad |
| 25 | Auswerteeinheit |
| 26 | Differenzsignal |
| 27 | Filter |
| 28 | Kalibriereinrichtung |
| 29 | Kalibrierpfad |
| ain | analoges Eingangssignal |
| REF | Referenzgröße |

**Patentansprüche**

**1.** A/D-Wandler, zur Umwandlung eines analogen Eingangssignals ($a_{in}$) in einen digitalen Ausgabewert mit:,

(a) mindestens einer Wandlerstufe, die jeweils aufweist:

(a1) eine Sample&Hold-Schaltung (3) zum Abtasten des analogen Eingangssignals ($A_{in}$),
(a2) eine Komparatoreinheit (5), die das Eingangssignal mit einem Referenzwert (REF) zum Erzeugen eines digitalen Ausgabewertes der Wandlerstufe vergleicht,
(a3) einen Digital/Analogwandler (13) zur Umwandlung des digitalen Ausgabewertes in eine analoges Signal,
(a4) einen Subtrahierer (11) zur Subtraktion des von dem Digital/Analogwandler (13) abgegebenen analogen Signals von dem abgetasteten Eingangssignal und
(a5) einen Signalverstärker (17) zum Verstärken des von dem Subtrahierer (11) abgegebenen Ausgangssignals mit einem bestimmten Signalverstärkungsfaktor (V) für die nächste Wandlerstufe und
(a6) eine Gewichtungseinheit (9) zur Multiplikation des digitalen Ausgabewertes mit einem Multiplikator zur Addition mit weiteren gewichteten Ausgabewerten von Wandlerstufen zu dem digitalen Ausgabewert des Analog/Digitalwandlers (1);

(b) einem Zufallssignalgenerator (19) zur Erzeugung eines Zufallssignals, das in die Wandlerstufe eingespeist wird;
**dadurch gekennzeichnet dass**:
(c) er mindestens eine Kalibriereinheit (21) enthält, die jeweils aufweist:

(c1) einen Kalibrierverstärker mit einstellbarem Kalibrierverstärkungsfaktor zur Signalverstärkung des Zufallssignals,
(c2) eine Auswerteeinheit, die das in den Signalpfad eingespeiste und durch die Wandlerstufe verstärkte Zufallssignal mit dem durch den Kalibrierverstärker der Kalibriereinheit (21) verstärkten Zufallssignal zur Erzeugung eines Einstellsignals für die Einstellung des Kalibrierverstärkungsfaktors derart korreliert, dass das Ausgangssignal der Auswerteeinheit minimal ist und somit der berechnete Kalibrierungsverstärkungsfaktor der Verstärkung (V), die durch den Digital/Analogwandler (13) und den Signalverstärker (17) der Wandlerstufe hervorgerufen wird, entspricht;

(d) wobei das Zufallssignal von dem Zufallsgenerator (19) über einen durch die Kalibriereinheit (21) steuerbaren Schalter an einen Kalibrierkondensator (31) innerhalb des Digital/ Analogwandlers (13) der Wandlerstufe zur Einspeisung in den Signalpfad angelegt wird;
(e) wobei das Zufallssignal an weitere DAC-Kondensatoren (25) innerhalb des Digital/Analogwandlers (13) zur Berechnung der jeweiligen Signalverstärkungen der DAC-Stufen des Digital/Analogwandlers (13) schaltbar ist und

wobei die Kalibriereinheit (21) aus den ermittelten Signalverstärkungen ($V_I$) der DAC-Stufen des Digital/Analogwandlers (13) die Signalverstärkungsdifferenzen $\Delta V_{IJ}$ zwischen den DAC-Stufen zur Berechnung eines Umschaltfehlers (DAC-Error) des Digital/Analogwandlers (13) berechnet.

2. Analog/Digitalwandler nach Anspruch 1,
**dadurch gekennzeichnet,**
**dass** der berechnete Umschaltfehler (DAC-Error) von dem digitalen Ausgabewert der Wandlerstufen mittels eines Subtrahierers (37) zur Fehlerkompensation abgezogen wird.

3. Analog/Digitalwandler nach Anspruch 1 oder 2,
**dadurch gekennzeichnet,**
**dass** die berechneten Signalverstärkungen ($V_I$) in Registern der Kalibriereinheit (21) zwischengespeichert werden.

4. Analog/Digitalwandler nach Anspruch 3,
**dadurch gekennzeichnet,**
**dass** die Kalibriereinheit (21) einen Mittelwert zwischen gespeicherten Signalverstärkungen berechnet.

5. Analog/Digitalwandler nach Anspruch 4,
**dadurch gekennzeichnet,**
**dass** der berechnete Mittelwert der Signalverstärkungen durch die Kalibriereinheit (21) als Multiplikator an die Gewichtungseinheit (9) der Wandlerstufe angelegt wird.

6. Analog/Digitalwandler nach einem der vorangehenden Ansprüche,
**dadurch gekennzeichnet,**
**dass** dem Kalibrierverstärker der Kalibriereinheit (21) eine Subtrahierschaltung nachgeschaltet ist, die das durch den Kalibrierverstärker verstärkte Signal von einem aus dem Signalpfad der Wandlerstufen abgeleiteten Signal subtrahiert und ein Differenzsignal an die Auswerteeinheit abgibt.

7. Analog/Digitalwandler nach Anspruch 6,
**dadurch gekennzeichnet,**
**dass** die Auswerteeinheit das Differenzsignal mit dem digitalen Zufallssignal kreuzkorreliert.

8. Analog/Digitalwandler nach Anspruch 7,
**dadurch gekennzeichnet,**
**dass** der Auswerteeinheit ein Filter nachgeschaltet ist.

9. Analog/Digitalwandler nach Anspruch 1,
**dadurch gekennzeichnet,**
**dass** die Kalibriereinheit (21) eine Ablaufsteuerung zur Generierung von Steuersignalen für die Ansteuerung von Schaltern aufweist.

10. Analog/Digitalwandler nach Anspruch 1,
**dadurch gekennzeichnet,**
**dass** die Ausgabewerte der Komparatoreinheiten (5) Thermometer-kodiert sind.

11. Analog/Digitalwandler nach Anspruch 1,
**dadurch gekennzeichnet,**
**dass** mindestens zwei Wandlerstufen vorgesehen sind.

12. Analog/Digitalwandler nach Anspruch 1,
**dadurch gekennzeichnet,**
**dass** das Zufallssignal ein digitales Zufallssignal (PSR) ist.

13. Analog/Digitalwandler nach Anspruch 1,
**dadurch gekennzeichnet,**
**dass** die Analog/Digitalwandler (1) voll differentiell aufgebaut sind.

14. Analog/Digitalwandler nach Anspruch 1
**dadurch gekennzeichnet,**
**dass** der Digital/Analogwandler (13) einen Kalibrierkondensator (31) aufweist über den das Zufallssignal in den Signalpfad eingespeist wird.

**Claims**

1. A/D converter, for converting an analog input signal ($a_{in}$) into a digital output value, having:

   (a) at least one converter stage which respectively has:

   (a1) a sample & hold circuit (3) for sampling the analog input signal ($a_{in}$),
   (a2) a comparator unit (5) which compares the input signal with a reference value (REF) in order to produce a digital output value from the converter stage,
   (a3) a digital/analog converter (13) for converting the digital output value into an analog signal,
   (a4) a subtractor (11) for subtracting the analog signal which is output by the digital/analog converter (13) from the sampled input signal, and
   (a5) a signal amplifier (17) for amplifying the output signal which is output by the subtractor (11) with a particular signal gain factor (V) for the next converter stage, and

(a6) a weighting unit (9) for multiplying the digital output value by a multiplier for addition to further weighted output values from converter stages to produce the digital output value from the analog/digital converter (1);

(b) a random signal generator (19) for generating a random signal which is fed into the converter stage;

(c) **characterized in that**: it contains at least one calibration unit (21) which respectively has:

(c1) a calibration amplifier with an adjustable calibration gain factor for signal amplification for the random signal, (c2) an evaluation unit which correlates the random signal which is fed into the signal path and is amplified by the converter stage with the random signal amplified by the calibration amplifier in the calibration unit (21), in order to generate a setting signal for setting the calibration gain factor, such that the output signal from the evaluation unit is at a minimum and hence the calculated calibration gain factor corresponds to the gain (V) which is brought about by the digital/analog converter (13) and the signal amplifier (17) in the converter stage;

(d) where the random generator (19) applies the random signal, via a switch which can be controlled by the calibration unit (21), to a calibration capacitor (31) within the digital/analog converter (13) in the converter stage in order to feed it into the signal path;

(e) where the random signal can be connected to further DAC capacitors (25) within the digital/analog converter (13) in order to calculate the respective signal gains of the DAC stages in the digital/analog converter (13), and where the calibration unit (21) uses the ascertained signal gains $(V_i)$ of the DAC stages in the digital/analog converter (13) to calculate the signal gain differences $\Delta V_{ij}$ between the DAC stages in order to calculate a transfer error (DAC error) for the digital/analog converter (13).

2. Analog/digital converter according to claim 1, **characterized in that** the calculated transfer error (DAC error) is deducted from the digital output value from the converter stages using a subtractor (37) in order to compensate for errors.

3. Analog/digital converter according to claim 1 or 2,

**characterized in that** the calculated signal gains $(V_i)$ are buffer-stored in registers in the calibration unit (21).

4. Analog/digital converter according to claim 3, **characterized in that** the calibration unit (21) calculates a mean value between stored signal gains.

5. Analog/digital converter according to claim 4, **characterized in that** the calculated mean value for the signal gains is applied as a multiplier to the weighting unit (9) in the converter stage by the calibration unit (21).

6. Analog/digital converter according to one of the preceding claims, **characterized in that** the calibration amplifier in the calibration unit (21) has a subtraction circuit connected downstream of it which subtracts the signal amplified by the calibration amplifier from a signal derived from the signal path in the converter stages and outputs a difference signal to the evaluation unit.

7. Analog/digital converter according to claim 6, **characterized in that** the evaluation unit cross-correlates the difference signal with the digital random signal.

8. Analog/digital converter according to claim 7, **characterized in that** the evaluation unit has a filter connected downstream of it.

9. Analog/digital converter according to claim 1, **characterized in that** the calibration unit (21) has a flow controller for generating control signals for actuating switches.

10. Analog/digital converter according to claim 1, **characterized in that** the output values from the comparator units (5) are thermometer-coded.

11. Analog/digital converter according to claim 1, **characterized in that** at least two converter stages are provided.

12. Analog/digital converter according to claim 1, **characterized in that** the random signal is a digital random signal (PSR).

13. Analog/digital converter according to claim 1, **characterized in that** the analog/digital converters (1) are of fully differential design.

**14.** Analog/digital converter according to claim 1, **characterized in that** the digital/analog converter (13) has a calibration capacitor (31) via which the random signal is fed into the signal path.

## Revendications

**1.** Convertisseur A/D pour la conversion d'un signal d'entrée analogique (ain) en une valeur de sortie numérique comprenant :

(a) au moins un étage de convertisseur qui comprend à chaque fois :

(a1) un circuit Sample&Hold (3) pour balayer le signal d'entrée analogique (Ain),
(a2) une unité de comparaison (5) qui compare le signal d'entrée avec une valeur de référence (REF) pour générer une valeur de sortie numérique de l'étage de convertisseur,
(a3) un convertisseur numérique/analogique (13) pour la conversion d'une valeur de sortie numérique en un signal analogique,
(a4) un soustracteur (11) pour soustraire le signal analogique délivré par le convertisseur numérique/analogique (13) du signal d'entrée balayé et
(a5) un amplificateur de signal (17) pour l'amplification du signal de sortie délivré par le soustracteur (11) avec un facteur d'amplification de signal déterminé (V) pour l'étage de convertisseur suivant et
(a6) une unité de pondération (9) pour la multiplication de la valeur de sortie numérique avec un multiplicateur pour l'addition avec d'autres valeurs de sortie pondérées des étages de convertisseur pour obtenir la valeur de sortie numérique du convertisseur analogique/numérique (1) ;

(b) un générateur de signal stochastique (19) pour la génération d'un signal stochastique envoyé dans les étages de convertisseur ;
**caractérisé en ce que**
(c) il comprend au moins une unité de calibrage (21) comprenant à chaque fois :

(c1) un amplificateur de calibrage avec un facteur d'amplification de calibrage réglable pour l'amplification de signal du signal stochastique,
(c2) une unité d'évaluation qui corrèle le signal stochastique envoyé dans le chemin de signal et amplifié par l'étage de convertisseur avec le signal stochastique amplifié par l'amplificateur de calibrage de l'unité de calibrage (21) pour la génération d'un signal de réglage pour le réglage du facteur d'amplification de calibrage de telle façon que le signal de sortie de l'unité d'évaluation est minimal et qu'ainsi le facteur d'amplification de calibrage calculé correspond à l'amplification (V) produite par le convertisseur numérique/analogique (13) et l'amplificateur de signal (17) de l'étage de convertisseur;

(d) dans lequel le signal stochastique du générateur stochastique (19) est appliqué, via un commutateur pouvant être commandé par l'unité de calibrage (21), à un condensateur de calibrage (31) à l'intérieur du convertisseur numérique/analogique (13) de l'étage de convertisseur pour l'entrée dans le chemin de signal ;
(e) dans lequel le signal stochastique peut être appliqué à d'autres condensateurs DAC (25) à l'intérieur du convertisseur numérique/analogique (13) pour le calcul des amplifications de signal respectives des étages DAC du convertisseur numérique/analogique (13) et dans lequel l'unité de calibrage (21) calcule à partir des amplifications de signal déterminées (VI) des étages DAC du convertisseur numérique/analogique (13) les différences d'amplification de signal $\Delta VIJ$ entre les étages DAC pour le calcul d'une erreur de commutation (DAC-error) du convertisseur numérique/analogique (13).

**2.** Convertisseur analogique/numérique selon la revendication 1,
**caractérisé en ce que**
l'erreur de commutation calculée (DAX-error) est soustraite de la valeur de sortie numérique des étages de convertisseur à l'aide d'un soustracteur (37) pour la compensation d'erreur.

**3.** Convertisseur analogique/numérique selon la revendication 1 ou 2,
**caractérisé en ce que**
les amplifications de signal calculées (VI) sont mémorisées temporairement dans des registres de l'unité de calibrage (21).

**4.** Convertisseur analogique/numérique selon la revendication 3,
**caractérisé en ce que**
l'unité de calibrage (21) calcule une valeur moyenne des amplifications de signal mémorisées.

**5.** Convertisseur analogique/numérique selon la revendication 4,
**caractérisé en ce que**
la valeur moyenne calculée des amplifications de signal est appliquée par l'unité de calibrage (21) à l'unité de pondération (9) de l'étage de convertisseur comme multiplicateur.

**6.** Convertisseur analogique/numérique selon l'une quelconque des revendications précédentes, **caractérisé en ce qu'** un circuit de soustraction est connecté en aval de l'amplificateur de calibrage de l'unité de calibrage (21), il soustrait le signal amplifié par l'amplificateur de calibrage d'un signal issu du chemin de signal des étages de convertisseur et délivre un signal de différence à l'unité d'évaluation.

**7.** Convertisseur analogique/numérique selon la revendication 6, **caractérisé en ce que** l'unité d'évaluation fait une corrélation croisée du signal de différence avec le signal stochastique numérique.

**8.** Convertisseur analogique/numérique selon la revendication 7, **caractérisé en ce que** l'unité d'évaluation est connectée en aval d'un filtre.

**9.** Convertisseur analogique/numérique selon la revendication 1, **caractérisé en ce que** l'unité de calibrage (21) comprend un contrôleur de déroulement pour générer des signaux de commande pour la commande de commutateurs.

**10.** Convertisseur analogique/numérique selon la revendication 1, **caractérisé en ce que** les valeurs de sortie des unités de comparaison (5) sont codées de façon thermométrique.

**11.** Convertisseur analogique/numérique selon la revendication 1, **caractérisé en ce qu'** on prévoit au moins deux étages de convertisseur.

**12.** Convertisseur analogique/numérique selon la revendication 1, **caractérisé en ce que** le signal stochastique est un signal stochastique (PSR) numérique.

**13.** Convertisseur analogique/numérique selon la revendication 1, **caractérisé en ce que** les convertisseurs analogique/numérique (1) sont construits de façon complètement différentielle.

**14.** Convertisseur analogique/numérique selon la revendication 1, **caractérisé en ce que**

le convertisseur numérique/analogique (13) comprend un condensateur de calibrage (31) via lequel le signal stochastique est envoyé dans le chemin de signal.

# FIG 1

Stand der Technik

FIG 1
Stand der Technik

Stufe A | Stufe B | Stufe C

FIG 2
Stand der Technik

# FIG 3

## Stand der Technik

FIG 4

EP 1 568 138 B1

# FIG 5